Europäisches Patentamt

European Patent Office

Office européen des brevets

(11) Publication number: **0 164 195**
**A2**

# EUROPEAN PATENT APPLICATION

(21) Application number: **85302611.0**

(22) Date of filing: **15.04.85**

(51) Int. Cl.⁴: **H 03 K 4/94,** H 03 K 6/00

(30) Priority: **31.05.84 GB 8413938**

(43) Date of publication of application: **11.12.85**
**Bulletin 85/50**

(84) Designated Contracting States: **AT BE CH DE FR IT LI LU NL SE**

(71) Applicant: **STANDARD TELEPHONES AND CABLES PUBLIC LIMITED COMPANY, 190 Strand, London, WC2R 1DU (GB)**

(72) Inventor: **Rokos, George Hedley Storm, 16, South Road, Bishops Stortford Hertfordshire (GB)**

(74) Representative: **Capsey, Sydney Ross et al, Standard Telephones and Cables Patent Department Edinburgh Way, Harlow Essex CM20 2SH (GB)**

(54) Generation of trapezoidal waveforms.

㊐ A circuit generating trapezoidal waveforms including a capacitor C each pole of which is connected to the outputs of individual identical emitter follower circuits T1, T2 responsive to balanced differential signal inputs S, S, each emitter follower circuit including a constant current source $I_sA$, $I_s\overline{A}$ feeding the emitter thereof, the outputs of the emitter follower circuits being connected also to control respective transistors T3, T4 of a long tail pair.

0164195

## GENERATION OF TRAPEZOIDAL WAVEFORMS

This invention relates to a circuit for generating trapezoidal waveforms, and is intended for use in, inter alia, local area networks, where it is connected to a data bus which conveys pulsed intelligence, usually at high bit rates. For commercial considerations such circuits are preferably implemented in integrated circuit form, along with other portions of the data bus circuitry such as transisterised voltage follower circuits, voltage difference detectors, comparator circuits, and astable multivibrator circuits, with which the waveform generator circuit is interfaced.

Data bus systems commonly employ 'balanced differential' signal arrangements, that is to say pairs of signal waveforms, e.g. square waves, are produced having equal amplitudes and frequencies but with opposite polarities.

According to the present invention there is provided a circuit generating trapezoidal waveforms including a capacitor each pole of which is connected to the outputs of individual emitter follower circuits responsive to balanced differential signal inputs, characterised in that each emitter follower circuit includes a constant current source feeding the emitter thereof, the outputs of the emitter follower circuits being connected also to control respective transistors of a long tail pair.

The invention will be described with reference to the accompanying drawings, in which:-

Fig. 1 is a schematic circuit diagram, and

Fig. 2 depicts certain waveforms relating to the circuit of Fig. 1.

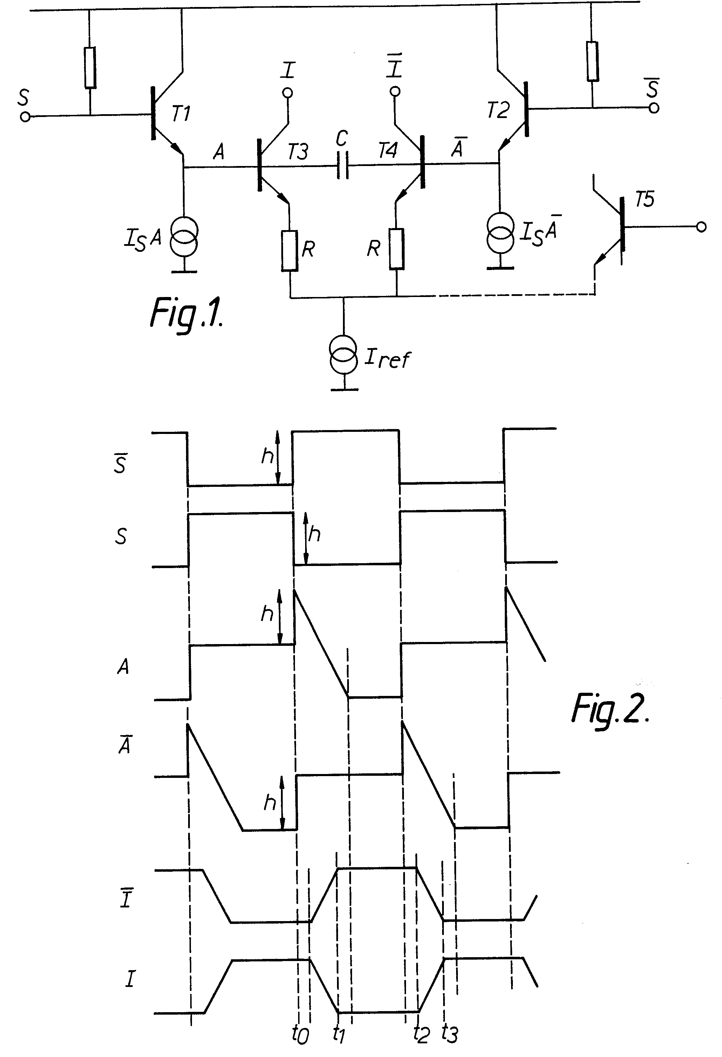

In the circuit of Fig. 1 a capacitor C is connected between the outputs of two identical emitter followers provided by transistors T1, T2. The emitter followers are fed by identical constant current sources $I_sA$ and $I_s\bar{A}$. Balanced differential input signals s, $\bar{s}$ are applied to the bases of transistors T1, T2. Capacitor C is also connected to the bases of transistors T3, T4 which, together with a constant current source $I_{ref}$, form a long tail pair.

Consider the situation when input signal $\bar{S}$ goes 'high' at time $t_o$ (and signal S goes 'low'). Initially the voltages A and $\bar{A}$ move together. The voltage A will then start falling according to

$$\frac{dA}{dt} \approx \frac{I_s}{C}$$

As A falls $\bar{A}$ remains constant and the long tail pair is unbalanced to produce approximately linear ramps on the current outputs I and $\bar{I}$. The ramping will start and stop when either $A-\bar{A}=S-\bar{S}$ (when A stops falling), or when $|A-\bar{A}|>I_{ref}xR$, where R is the resistance in the emitter of the long tail pair transistor, when all available current will flow in output $\bar{I}$ (to first order). The time constant of the circuit is designed so that this condition is reached at time $t_1$. Since the long tail pair is fed by the single constant current source $I_{ref}$, as the $\bar{I}$ current rises to its maximum there is a corresponding decrease in the current I. From time $t_1$ to time $t_2$ a steady state condition exists for both I and $\bar{I}$. Then signal $\bar{S}$ goes low and S goes high. Voltage A is pulled up immediately by transistor T1 and voltage $\bar{A}$

is momentarily increased by T1 acting through capacitor C. But then, whilst A remains constant, $\overline{A}$ starts to fall, discharging via $I_s\overline{A}$, and current $\overline{I}$ begins to fall whilst current I begins to rise. By the time $t_3$ is reached, when $\overline{A}$ ceases to fall, the changeover in currents I and $\overline{I}$ is completed.

The circuit of Fig. 1 is depicted in its simplest form. For example, a further emitter follower transistor T5 may have its output connected to the long tail pair current source $I_{ref}$ so that the action of the circuit may be inhibited by the application of a signal to the base of T5.

The circuit of Fig. 1 is particularly suited to converting logic waveforms to trapezoidal waveforms in a data bus transceiver when used in conjunction with a voltage follower as disclosed in our co-pending British application No. 8412036, a voltage difference detector as disclosed in British application No. 8413227 and/or a comparator as disclosed in British application No. 8413228.

CLAIMS:-

1.      A circuit generating trapezoidal waveforms including a capacitor each pole of which is connected to the outputs of individual emitter follower circuits responsive to balanced differential signal inputs, characterised in that each emitter follower circuit includes a constant current source feeding the emitter thereof, the outputs of the emitter follower circuits being connected also to control respective transistors of a long tail pair.

2.      A circuit according to claim 1 further characterised in that an additional emitter follower is included the output of which is connected to the constant current source feeding the long tail pair whereby the operation of the waveform generating circuit can be inhibited by the application of a control signal to the further emitter follower.

3.      A circuit for generating trapezoidal waveforms substantially as described with reference to the accompanying drawings.

0164195

1/1

Fig.1.

Fig.2.